# EUROPEAN PATENT APPLICATION

(11) **EP 4 628 913 A1**
(43) Date of publication of application: **08.10.2025**
(21) Application number: 23907511.2
(22) Date of filing: 05.12.2023
(51) Int. Cl.: G01R 31/396, G01R 31/392, G01R 31/382, G01R 31/385, G01R 31/367, G01R 19/12, B60R 16/033, B60L 58/10

(54) **BATTERY DATA MANAGEMENT DEVICE AND OPERATION METHOD THEREFOR**

(30) Priority: 22.12.2022 KR 20220182370
(71) Applicant: LG Energy Solution, Ltd., Seoul 07335 (KR)
(72) Inventor: CHUN, Joo Young, Daejeon 34122 (KR); CHUNG, Mi Kyung, Daejeon 34122 (KR); JEGAL, Seon Young, Daejeon 34122 (KR); KOH, Dong Wook, Daejeon 34122 (KR)
(74) Representative: Plasseraud IP
(86) International application number: PCT/KR2023/019910
(87) International publication number: WO 2024/136225

(57) **Abstract**

A battery data management apparatus according to an embodiment disclosed herein includes a data managing unit configured to generate voltage change information with respect to a state of charge (SOC) of a battery, based on battery data and a controller configured to calculate a voltage change function with respect to a charging/discharging rate (C-rate) of the battery based on battery data in a specific lifetime state of the battery among the battery data and generate open circuit voltage (OCV) change information with respect to the SOC of the battery based on the voltage change function with respect to the C-rate of the battery and the voltage change information with respect to the SOC of the battery.

## Description

### [TECHNICAL FIELD]

### CROSS-REFERENCE TO RELATED APPLICATION

This application claims priority to and the benefit of Korean Patent Application No. 10-2022-0182370 filed in the Korean Intellectual Property Office on December 22, 2022, the entire content of which is incorporated herein by reference.

### TECHNICAL FIELD

Embodiments disclosed herein relate to a battery data management apparatus and an operating method thereof.

### [BACKGROUND ART]

An electric vehicle is supplied with electricity from outside to charge a battery cell, and then a motor is driven by a voltage charged in the battery cell to obtain power. The battery cell of the electric vehicle may have heat generated therein by chemical reaction occurring in a process of charging and discharging electricity, and the heat may impair performance and lifetime of the battery cell.

As battery cells are repeatedly used and charged and discharged, they age, their lives are gradually shortened. The lifetime of the battery cell is greatly affected by conditions such as a use temperature, a use period, a charging voltage, the number of times of discharging, etc., and thus may not be accurately diagnosed merely by measuring the remaining capacity of the battery cell. Thus, to estimate the remaining lifetime of the battery, a process of calculating an accurate open circuit voltage (OCV) of the battery is required.

However, a conventional method of calculating an OCV of a battery includes measuring a voltage behavior of the battery by charging/discharging the battery with low current using a separate charging/discharging device, and the method needs a long time and resources for OCV measurement.

### [DISCLOSURE]

### [TECHNICAL PROBLEM]

Embodiments disclosed herein aim to provide a battery data management apparatus and an operating method thereof, in which an accurate OCV graph of a battery may be derived to estimate the lifetime of the battery.

Technical problems of the embodiments disclosed herein are not limited to the above-described technical problems, and other unmentioned technical problems would be clearly understood by one of ordinary skill in the art from the following description.

### [TECHNICAL SOLUTION]

A battery data management apparatus according to an embodiment disclosed herein includes a data managing unit configured to generate voltage change information with respect to a state of charge (SOC) of a battery, based on battery data and a controller configured to calculate a voltage change function with respect to a charging/discharging rate (C-rate) of the battery based on battery data in a specific lifetime state of the battery among the battery data and generate open circuit voltage (OCV) change information with respect to the SOC of the battery based on the voltage change function with respect to the C-rate of the battery and the voltage change information with respect to the SOC of the battery.

According to an embodiment, the data managing unit may be further configured to remove noise of the voltage change information with respect to the SOC of the battery by using a Kalman filter.

According to an embodiment, the data managing unit may be further configured to divide the voltage change information with respect to the SOC of the battery by the SOC and arrange the voltage change information at specific intervals.

According to an embodiment, the controller may be further configured to calculate a quadratic coefficient of the voltage change function with respect to the C-rate of the battery by fitting voltage data with respect to a predetermined C-rate of the battery, included in battery data in a beginning of life (BOL) state of the battery.

According to an embodiment, the controller may be further configured to divide the voltage change information with respect to the SOC of the battery into charging data and discharging data for each SOC of the battery and
calculate the voltage change information with respect to the C-rate for each SOC of the battery by applying the charging data and the discharging data for each SOC of the battery and the quadratic coefficient to interpolation.

According to an embodiment, the controller may be further configured to calculate the OCV for each SOC of the battery by extracting an OCV that is a voltage value of the battery when the C-rate of the battery is '0' from the voltage change information with respect to the C-rate for each SOC of the battery.

According to an embodiment, the controller may be further configured to generate OCV change information with respect to the SOC by inputting the OCV for each SOC of the battery to a window filter to smooth the OCV.

An operating method of a battery data management apparatus according to an embodiment disclosed herein includes generating voltage change information with respect to a state of charge (SOC) of a battery, based on battery data, removing noise of the voltage change information with respect to the SOC of the battery by using a Kalman filter, calculating a voltage change function with respect to a charging/discharging rate (C-rate) of the battery based on battery data in a specific lifetime state of the battery among the battery data, and generating open circuit voltage (OCV) change information with respect to the SOC of the battery based on the voltage change function with respect to the C-rate of the battery and the voltage change information with respect to the SOC of the battery.

According to an embodiment, the generating of the voltage change information with respect to the SOC of the battery based on the battery data may include dividing the voltage change information with respect to the SOC of the battery by the SOC and arrange the voltage change information at specific intervals.

According to an embodiment, the calculating of the voltage change function with respect to the C-rate of the battery based on the battery data in the specific lifetime state of the battery among the battery data may include calculating a quadratic coefficient of the voltage change function with respect to the C-rate of the battery by fitting voltage data with respect to a predetermined C-rate of the battery, included in battery data in a beginning of life (BOL) state of the battery.

According to an embodiment, the generating of the OCV change information with respect to the SOC of the battery based on the voltage change function with respect to the C-rate of the battery and the voltage change information with respect to the SOC of the battery may include dividing the voltage change information with respect to the SOC of the battery into charging data and discharging data for each SOC of the battery and calculating the voltage change information with respect to the C-rate for each SOC of the battery by applying the charging data and the discharging data for each SOC of the battery and the quadratic coefficient to interpolation.

According to an embodiment, the generating of the OCV change information with respect to the SOC of the battery based on the voltage change function with respect to the C-rate of the battery and the voltage change information with respect to the SOC of the battery may include calculating the OCV for each SOC of the battery by extracting an OCV that is a voltage value of the battery when the C-rate of the battery is '0' from the voltage change information with respect to the C-rate for each SOC of the battery.

According to an embodiment, the generating of the OCV change information with respect to the SOC of the battery based on the voltage change function with respect to the C-rate of the battery and the voltage change information with respect to the SOC of the battery may include generating OCV change information with respect to the SOC by inputting the OCV for each SOC of the battery to a window filter to smooth the OCV.

### [ADVANTAGEOUS EFFECTS]

With a battery data management apparatus and an operating method thereof according to an embodiment disclosed herein, an accurate OCV graph of a battery may be derived to estimate the lifetime of the battery.

### [DESCRIPTION OF DRAWINGS]

FIG. 1 illustrates a battery pack according to an embodiment disclosed herein.
FIG. 2 is a block diagram showing a configuration of a battery data management apparatus according to an embodiment disclosed herein.
FIG. 3 is a graph showing a voltage change with respect to SOC of the battery, according to an embodiment disclosed herein.
FIG. 4 is a graph showing an operation, performed by a controller, of calculating a voltage change function with respect to a charging/discharging rate of a battery, according to an embodiment disclosed herein.
FIG. 5 is a view showing an operation, performed by a controller, of calculating an OCV for each SOC of the battery, according to an embodiment disclosed herein.
FIG. 6 is a graph showing an OCV change with respect to SOC of the battery, according to an embodiment disclosed herein.
FIG. 7 is a graph showing an OCV change with respect to SOC of the battery, according to another embodiment disclosed herein.
FIG. 8 is a flowchart showing an operating method of a battery data management apparatus, according to an embodiment disclosed herein.
FIG. 9 is a block diagram showing a hardware configuration of a computing system for performing an operating method of a battery data management apparatus, according to an embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

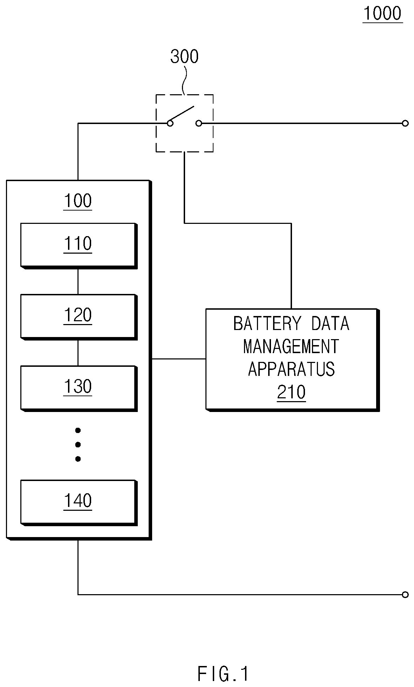

FIG. 1 illustrates a battery pack according to an embodiment disclosed herein.

Referring to FIG. 1, a battery pack 1000 according to an embodiment disclosed herein may include a battery module 100, a battery data management apparatus 200, and a relay 300. According to various embodiments, the battery module 100 may be a battery cell, and in this case, the battery pack 1000 may have a cell-to-pack structure.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

According to an embodiment, the battery data management apparatus 200 may be implemented in the form of a battery management system (BMS). Moreover, according to an embodiment, the battery data management apparatus 200 may be mounted on a battery management system.

The battery data management apparatus 200 may predict a lifetime, i.e., a state of health (SOH), of the plurality of battery cells 110, 120, 130, and 140 based on temperature and voltage data of the plurality of battery cells 110, 120, 130, and 140. The battery data management apparatus 200 may remove nose of battery data of the plurality of battery cells 110, 120, 130, and 140, and predict the SOH of the plurality of battery cells 110, 120, 130, and 140 based on data from which the noise is removed.

The battery data management apparatus 200 may manage and/or control a state and/or an operation of the battery module 100. For example, the battery data management apparatus 200 may manage and/or control the states and/or operations of the plurality of battery cells 110, 120, 130, and 140 included in the battery module 100. The battery data management apparatus 200 may manage charging and/or discharging of the battery module 100.

The battery data management apparatus 200 may control an operation of the relay 300. For example, the battery data management apparatus 200 may short-circuit the relay 300 to supply power to the target device. The battery data management apparatus 200 may short-circuit the relay 300 when a charging device is connected to the battery pack 1000.

In addition, the battery data management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery data management apparatus 200, which are not shown, may be additionally installed in the battery module 100, a charging/discharging path, any position of the battery module 100, etc. The battery data management apparatus 200 may calculate a parameter indicating a state of the battery module 100, e.g., a state of charge (SOC), based on a measurement value such as monitored voltage, current, temperature, etc.

The battery data management apparatus 200 may estimate a degradation factor of each of a positive electrode and a negative electrode separately for a state of the positive electrode and the negative electrode of the battery to evaluate an SOH of the battery, i.e., the lifetime of the battery. In this case, the battery data management apparatus 200 may analyze an open circuit voltage (OCV) of the battery to estimate a degradation factor of each of the positive electrode and the negative electrode of the battery. Herein, the OCV may mean a voltage measured when the current of the battery does not flow. That is, the OCV may be a voltage between both electrodes in a state where a fuel electrode (anode) and an air electrode (cathode) of the battery are not electrically connected to each other. According to the Ohm's law, as the battery's resistance increases infinitely, the current may approach '0', thereby accurately measuring a voltage of the battery. Thus, the battery data management apparatus 200 may measure and analyze the OCV of the battery for accurate electrochemical analysis of the battery.

The battery data management apparatus 200 may analyze a degradation factor of each of the positive electrode and the negative electrode, such as a loss of lithium inventory (LLI), a loss of active material-negative electrode (LAMn), a loss of active material-positive electrode (LAMp), etc., by differentiating the OCV of the battery. Herein, the LLI, which is a loss of lithium inventory, means how much lithium of the battery cell decreases with respect to BOL, the LAMn means how much the positive electrode active material of the battery decreases with respect to BOL, and the LAMp means how much the negative electrode active material of the battery decreases with respect to BOL. For example, the battery data management apparatus 200 may extract the LLI, the LAMn, or the LAMp, which is the degradation factor of the battery, by using an artificial intelligence model for analyzing the OCV of the battery or a mathematical modeling technique for calculating the degradation factor of the battery.

The battery data management apparatus 200 may calculate an OCV graph of the battery based on predetermined experiment data of a vehicle having the battery pack 1000 mounted thereon. That is, the battery data management apparatus 200 may derive a continuous OCV curve of the battery by analyzing and processing predetermined battery data.

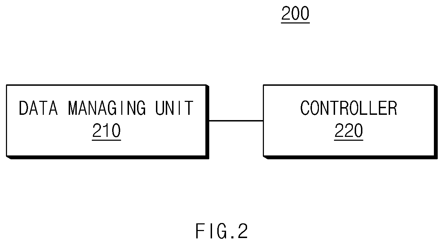

FIG. 2 is a view for describing in detail a configuration of a battery data management apparatus according to an embodiment disclosed herein.

Hereinbelow, a configuration of the battery data management apparatus 200 will be described in detail with reference to FIG. 2.

Referring to FIG. 2, the battery data management apparatus 200 may include a data managing unit 210 and a controller 220.

The data managing unit 210 may obtain battery data of the plurality of battery cells 110, 120, 130, and 140. Herein, the battery data may include voltage V, current I, temperature T, capacity Q, etc., of the plurality of battery cells 110, 120, 130, and 140. More specifically, the data managing unit 210 may collect driving experiment data of the vehicle having the battery pack 1000 mounted thereon and extract the battery data. For example, the data managing unit 210 may select a predetermined battery cell having undergone deterioration to a large extent or a predetermined battery cell having undergone deterioration to a small extent, included in the driving experiment data of the vehicle having the battery pack 1000 mounted thereon and analyze battery data of the corresponding battery cell.

The data managing unit 210 may collect the battery data generated as a plurality of charging/discharging cycles of the plurality of battery cells 110, 120, 130, and 140 progress, and classify the battery data for each charging/discharging cycle. Herein, the cycle may include an operating period of the battery data management apparatus 200 such as Power ON/OFF, Ignition ON/OFF, etc., of the battery data management apparatus 200.

The data managing unit 210 may generate voltage change information with respect to an SOC of the battery based on the battery data of the plurality of battery cells 110, 120, 130, and 140. According to an embodiment, the data managing unit 210 may calculate an SOC of the plurality of battery cells 110, 120, 130, and 140 by using current accumulation. Herein, the current accumulation may be a method of determining an SOC of a battery cell by integrating a charging current and a discharging current of the battery cell over time.

According to an embodiment, the data managing unit 210 may collect SOC data for each charging/discharging cycle of the plurality of battery cells 110, 120, 130, and 140 based on the battery data generated as the plurality of charging/discharging cycles of the plurality of battery cells 110, 120, 130, and 140 progress. The data managing unit 210 may generate single SOC data by connecting an end of SOC data for a previous cycle to SOC data of a next cycle in SOC data of each charging/discharging cycle of the plurality of battery cells 110, 120, 130, and 140.

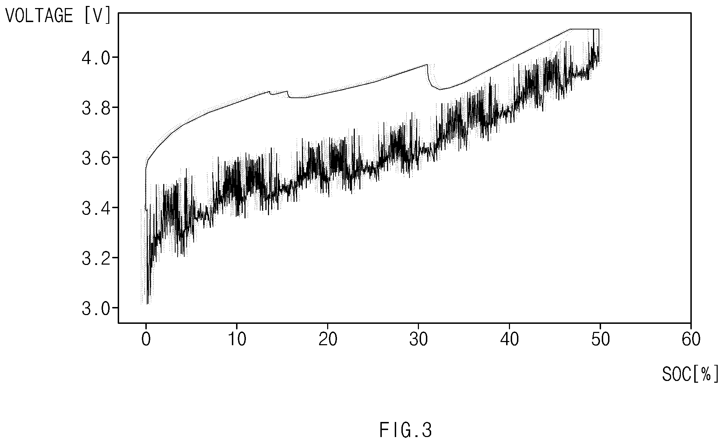

FIG. 3 is a graph showing a voltage change with respect to SOC of the battery, according to an embodiment disclosed herein.

Referring to FIG. 3, the data managing unit 210 may generate voltage change information with respect to an SOC of the plurality of battery cells 110, 120, 130, and 140 based on the battery data of the plurality of battery cells 110, 120, 130, and 140. That is, the data managing unit 210 may generate an SOC-V profile of the plurality of battery cells 110, 120, 130, and 140.

According to an embodiment, the data managing unit 210 may generate the voltage change information with respect to the SOC of the plurality of battery cells 110, 120, 130, and 140 based on the battery data generated as the plurality of charging/discharging cycles of the plurality of battery cells 110, 120, 130, and 140 progress, and plot the voltage change information on a display (not provided).

The data managing unit 210 may remove noise of the battery data of the plurality of battery cells 110, 120, 130, and 140. According to an embodiment, the data managing unit 210 may remove noise of the voltage change information with respect to the SOC of the plurality of battery cells 110, 120, 130, and 140 by using a Kalman filter. Herein, the Kalman filter may be an algorithm including state prediction and update of a measurement value. More specifically, the Kalman filter may remove noise included in new measurement data by using past measurement data and the new measurement data to predict a next measurement value.

The data managing unit 210 may remove the noise of the voltage change information with respect to the SOC of the plurality of battery cells 110, 120, 130, and 140 by using the Kalman filter to calculate accurate SOC data for each charging/discharging cycle of the plurality of battery cells 110, 120, 130, and 140. That is, the data managing unit 210 may correct an error of the voltage change information with respect to the SOC of the plurality of battery cells 110, 120, 130, and 140 based on the noise-removed voltage change information with respect to the SOC of the plurality of battery cells 110, 120, 130, and 140.

According to an embodiment, the data managing unit 210 may divide the voltage change information with respect to the SOC of the plurality of battery cells 110, 120, 130, and 140 by SOC and arrange the voltage change information at specific intervals. For example, the data managing unit 210 may divide the voltage change information with respect to the SOC of the plurality of battery cells 110, 120, 130, and 140 by SOC and generate a data frame.

For example, the data managing unit 210 may divide the battery data of the plurality of battery cells 110, 120, 130, and 140 by SOC based on interpolation and arrange the battery data at specific intervals. Herein, interpolation, which is a method of standardization in the form of a polynomial based on given data, may estimate data that is not obtained through observation or experiment. The data managing unit 210 may correct the voltage change information with respect to the SOC of the plurality of battery cells 110, 120, 130, and 140 at specific intervals, based on interpolation.

The controller 220 may calculate OCV change information with respect to the SOC of the plurality of battery cells 110, 120, 130, and 140 based on the voltage change information with respect to the SOC of the plurality of battery cells 110, 120, 130, and 140.

First, the controller 220 may calculate a voltage change function with respect to a charging/discharging rate (C-rate) of the battery cells 110, 120, 130, and 140 based on the battery data arranged at specific intervals with respect to the SOC of the plurality of battery cells 110, 120, 130, and 140.

The controller 220 may calculate the voltage change function with respect to the charging/discharging rate of the plurality of battery cells 110, 120, 130, and 140 based on battery data in a specific lifetime state of the plurality of battery cells 110, 120, 130, and 140 among the battery data. Herein, the specific lifetime state may include a beginning of life (BOL), a middle of life (MOL), and an end of life (EOL) of the battery.

According to an embodiment, the controller 220 may calculate the voltage change function with respect to the charging/discharging rate of the plurality of battery cells 110, 120, 130, and 140 based on battery data in the BOL state of the plurality of battery cells 110, 120, 130, and 140 among the battery data.

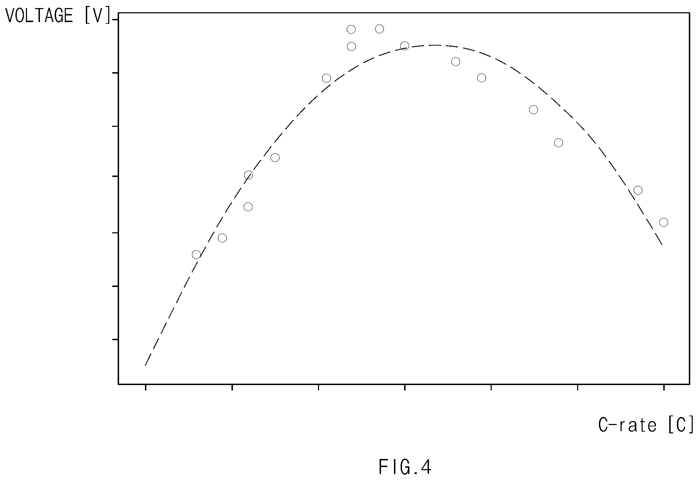

FIG. 4 is a graph showing an operation, performed by a controller, of calculating a voltage change function with respect to a charging/discharging rate of a battery, according to an embodiment disclosed herein.

Referring to FIG. 4, the controller 220 may extract predetermined battery data included in the battery data in the BOL state of the plurality of battery cells 110, 120, 130, and 140. For example, the controller 220 may extract first battery data that is charging data (indicating a positive (+) C-rate) of the battery, second battery data that is discharging data (indicating a negative (-) C-rate) of the battery, and third battery data that is OCV data (indicating a C-rate of '0') of the battery, among the battery data in the BOL state of the plurality of battery cells 110, 120, 130, and 140. Herein, the first battery data, the second battery data, and the third battery data may include the voltage V, the current I, the temperature T, the capacity Q, etc., of the battery cell, measured in the BOL state of the battery cell, such that the first battery data, the second battery data, and the third battery data may have the same SOC.

The controller 220 may fit the first battery data, the second battery data, and the third battery data. For example, the controller 220 may fit the voltage V data with respect to the C-rate of the battery cell, included in the first battery data, the second battery data, and the third battery data. The controller 220 may calculate the voltage change function with respect to the charging/discharging rate of the plurality of battery cells 110, 120, 130, and 140 by fitting the first battery data, the second battery data, and the third battery data.

The controller 220 may extract a gradient value of a graph formed by fitting the first battery data, the second battery data, and the third battery data. That is, the controller 220 may calculate a quadratic coefficient C of the voltage change function with respect to the charging/discharging rate of the plurality of battery cells 110, 120, 130, and 140, calculated by fitting the first battery data, the second battery data, and the third battery data. For example, the controller 220 may calculate the voltage change function with respect to the charging/discharging rate of '-0.7x²+7.173x-30.25' by fitting the first battery data, the second battery data, and the third battery data. Herein, the controller 220 may extract '-0.7' as the quadratic coefficient C of the function.

The controller 220 may generate OCV change information with respect to the SOC of the plurality of battery cells 110, 120, 130, and 140 based on the voltage change function with respect to the C-rate in the BOL state of the plurality of battery cells 110, 120, 130, and 140, and the voltage change information with respect to the SOC of the plurality of battery cells 110, 120, 130, and 140.

More specifically, the controller 220 may calculate the OCV for each SOC of the plurality of battery cells 110, 120, 130, and 140 by applying the voltage change information with respect to the SOC of the plurality of battery cells 110, 120, 130, and 140 and the quadratic coefficient C of the voltage change function with respect to the charging/discharging rate in the BOL state of the plurality of battery cells 110, 120, 130, and 140 to interpolation.

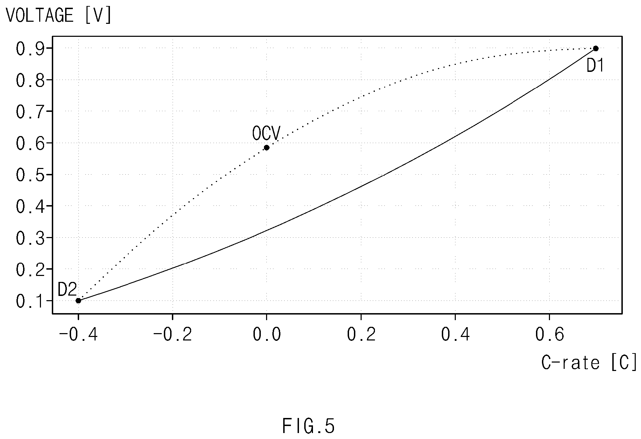

FIG. 5 is a view showing an operation, performed by a controller, of calculating an OCV for each SOC of the battery, according to an embodiment disclosed herein.

Referring to FIG. 5, the controller 220 may obtain charging data D1 (indicating a positive (+) C-rate) and discharging data D2 (indicating a negative (-) C-rate) for each SOC, generated by dividing the voltage change information with respect to the SOC of the plurality of battery cells 110, 120, 130, and 140 by SOC. That is, the controller 220 may obtain two data points corresponding to the charging data D1 and the discharging data D2 for each SOC of the plurality of battery cells 110, 120, 130, and 140.

The controller 220 may perform quadratic fitting that fits the two data points corresponding to the charging data D1 and the discharging data D2 for each SOC of the plurality of battery cells 110, 120, 130, and 140 and the quadratic coefficient C of the voltage change function with respect to the charging/discharging rate in the BOL state of the plurality of the battery cells 110, 120, 130, and 140.

The controller 220 may use '0' C-rate interpolation that connects two points by using the two data points corresponding to the charging data D1 and the discharging data D2 for each SOC and the quadratic coefficient C, and then fins a point at which an x coordinate is '0'. More specifically, the controller 220 may apply the two data points corresponding to the charging data D1 and the discharging data D2 for each SOC of the plurality of battery cells 110, 120, 130, and 140 and the quadratic coefficient C of the voltage change function with respect to the charging/discharging rate of the plurality of battery cells 110, 120, 130, and 140 to interpolation to extract an OCV that is a voltage value of a battery cell when a charging/discharging rate of the battery is '0', thereby calculating an OCV for each SOC of the battery.

For example, the controller 220 may obtain the charging data D1, 'C-rate: 0.7 C, V: 0.9 V' and the discharging data D2, 'C-rate: -0.4 C, V: 0.1 V' of the plurality of battery cells 110, 120, 130, and 140 in a specific SOC. The controller 220 may fit both the charging data D1 and the discharging data D2 and the quadratic coefficient C of '-0.7' of the voltage change function with respect to the charging/discharging rate in the BOL state of the plurality of battery cells 110, 120, 130, and 140, thereby calculating the quadratic function of '-0.7x² + 0.94x + 0.5'. The controller 220 may calculate an x coordinate in the quadratic function, i.e., an OCV that is a voltage value as '0.59' when the C-rate is '0'.

The controller 220 may calculate an OCV for each SOC of the plurality of battery cells 110, 120, 130, and 140 and then collect the OCV for each SOC of the plurality of battery cells 110, 120, 130, and 140 to generate OCV change information with respect to the SOC of the plurality of battery cells 110, 120, 130, and 140.

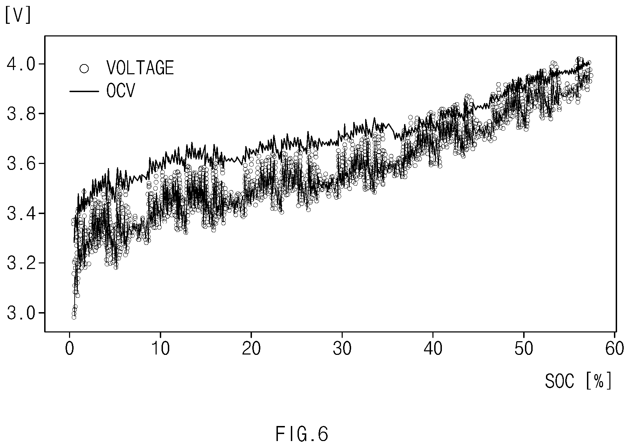

FIG. 6 is a graph showing an OCV change with respect to SOC of the battery, according to an embodiment disclosed herein.

Referring to FIG. 6, the controller 220 may generate OCV change information with respect to an SOC of the plurality of battery cells 110, 120, 130, and 140 by connecting the OCV calculated for each SOC of the plurality of battery cells 110, 120, 130, and 140.

The controller 220 may input the OCV for each SOC of the plurality of battery cells 110, 120, 130, and 140 into a window-based filter for smoothing and generate the OCV change information with respect to the SOC of the plurality of battery cells 110, 120, 130, and 140.

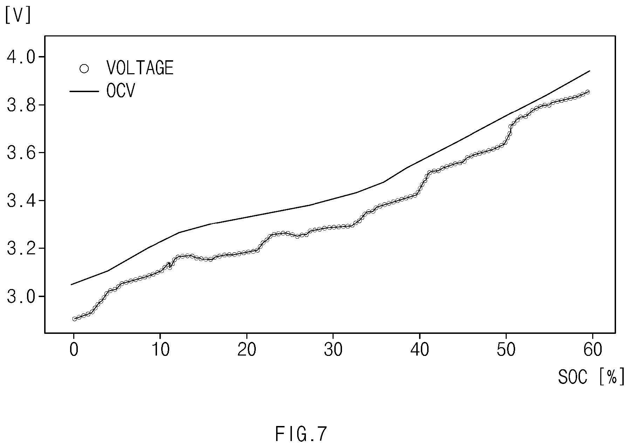

FIG. 7 is a graph showing an OCV change with respect to SOC of the battery, according to another embodiment disclosed herein.

Referring to FIG. 7, the controller 220 may input the OCV for each SOC of the plurality of battery cells 110, 120, 130, and 140 to the window-based filter for smoothing. The controller 220 may derive a smooth OCV curve by smoothing the OCV for each SOC of the plurality of battery cells 110, 120, 130, and 140.

As described above, with the battery data management apparatus 200 according to an embodiment disclosed herein, it is possible to generate an accurate OCV graph of the battery for lifetime estimation of the battery.

For the battery data management apparatus 200, a short time is required for calculation of the OCV of the battery, and when the battery is diagnosed as being in an abnormal state by constantly determining the state thereof the user may be immediately provided with information.

Moreover, the battery data management apparatus 200 may improve the accuracy of prediction of the lifetime of the battery by obtaining the noise-removed battery data.

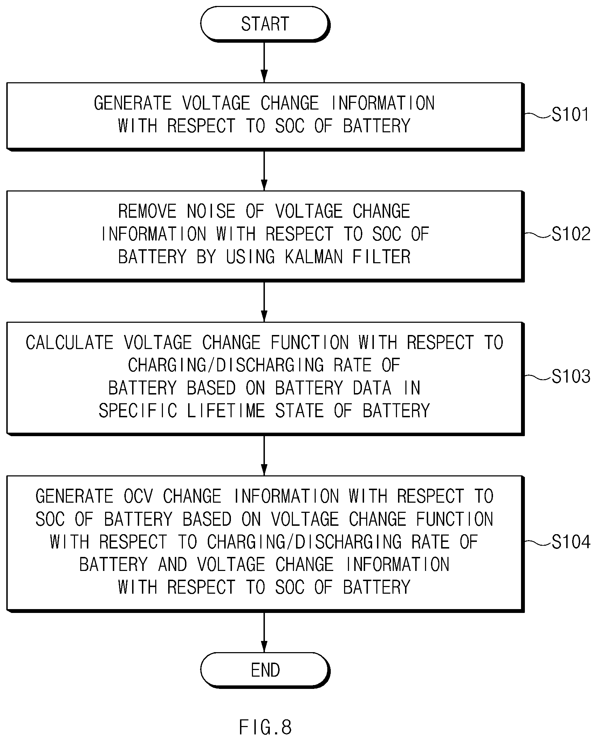

FIG. 8 is a flowchart showing an operating method of a battery data management apparatus, according to an embodiment disclosed herein. Hereinbelow, an operating method of the battery data management apparatus 200 will be described with reference to FIGS. 1 to 7.

The battery data management apparatus 200 may be substantially the same as the battery data management apparatus 200 described with reference to FIGS. 1 to 7, and thus will be briefly described to avoid redundant description.

Referring to FIG. 8, an operating method of the battery data management apparatus 200 may include operation S101 of generating voltage change information with respect to an SOC of a battery based on battery data, operation S102 of removing noise of the voltage change information with respect to the SOC of the battery by using a Kalman filter, operation S103 of calculating a voltage change function with respect to a C-rate of the battery based on battery data in a specific lifetime state of the battery among the battery data, and operation S104 of generating OCV change information with respect to the SOC of the battery based on the voltage change function with respect to the C-rate of the battery and the voltage change information with respect to the SOC of the battery.

In operation S101, the data managing unit 210 may obtain battery data of the plurality of battery cells 110, 120, 130, and 140. Herein, the battery data may include voltage V, current I, temperature T, capacity Q, etc., of the plurality of battery cells 110, 120, 130, and 140. In operation S101, more specifically, the data managing unit 210 may collect driving experiment data of the vehicle having the battery pack 1000 mounted thereon and extract the battery data. In operation S101, for example, the data managing unit 210 may select a predetermined battery cell having undergone deterioration to a large extent or a predetermined battery cell having undergone deterioration to a small extent, included in the driving experiment data of the vehicle having the battery pack 1000 mounted thereon and analyze battery data of the corresponding battery cell.

In operation S101, the data managing unit 210 may collect the battery data generated as a plurality of charging/discharging cycles of the plurality of battery cells 110, 120, 130, and 140 progress, and classify the battery data for each charging/discharging cycle.

In operation S101, the data managing unit 210 may generate voltage change information with respect to an SOC of the battery based on the battery data of the plurality of battery cells 110, 120, 130, and 140. According to an embodiment, the data managing unit 210 may calculate an SOC of the plurality of battery cells 110, 120, 130, and 140 by using current accumulation.

In operation S101, according to an embodiment, the data managing unit 210 may collect SOC data for each charging/discharging cycle of the plurality of battery cells 110, 120, 130, and 140 based on the battery data generated as the plurality of charging/discharging cycles of the plurality of battery cells 110, 120, 130, and 140 progress. In operation S101, the data managing unit 210 may generate single SOC data by connecting an end of SOC data for a previous cycle to SOC data of a next cycle in SOC data of each charging/discharging cycle of the plurality of battery cells 110, 120, 130, and 140.

In operation S101, the data managing unit 210 may generate voltage change information with respect to an SOC of the plurality of battery cells 110, 120, 130, and 140 based on the battery data of the plurality of battery cells 110, 120, 130, and 140. In operation S101, that is, the data managing unit 210 may generate an SOC-V profile of the plurality of battery cells 110, 120, 130, and 140.

In operation S101, according to an embodiment, the data managing unit 210 may generate the voltage change information with respect to the SOC of the plurality of battery cells 110, 120, 130, and 140 based on the battery data generated as the plurality of charging/discharging cycles of the plurality of battery cells 110, 120, 130, and 140 progress, and plot the voltage change information on a display (not provided).

In operation S102, the data managing unit 210 may remove noise of the battery data of the plurality of battery cells 110, 120, 130, and 140. In operation S102, according to an embodiment, the data managing unit 210 may remove noise of the voltage change information with respect to the SOC of the plurality of battery cells 110, 120, 130, and 140 by using a Kalman filter.

In operation S102, the data managing unit 210 may remove the noise of the voltage change information with respect to the SOC of the plurality of battery cells 110, 120, 130, and 140 by using the Kalman filter to calculate accurate SOC data for each charging/discharging cycle of the plurality of battery cells 110, 120, 130, and 140. In operation S102, that is, the data managing unit 210 may correct an error of the voltage change information with respect to the SOC of the plurality of battery cells 110, 120, 130, and 140 based on the noise-removed voltage change information with respect to the SOC of the plurality of battery cells 110, 120, 130, and 140.

In operation S102, according to an embodiment, the data managing unit 210 may divide the voltage change information with respect to the SOC of the plurality of battery cells 110, 120, 130, and 140 by SOC and arrange the voltage change information at specific intervals. In operation S102, for example, the data managing unit 210 may divide the voltage change information with respect to the SOC of the plurality of battery cells 110, 120, 130, and 140 by SOC and generate a data frame.

In operation S102, for example, the data managing unit 210 may divide the battery data of the plurality of battery cells 110, 120, 130, and 140 by SOC based on interpolation and arrange the battery data at specific intervals. In operation S102, the data managing unit 210 may correct the voltage change information with respect to the SOC of the plurality of battery cells 110, 120, 130, and 140 at specific intervals, based on interpolation.

In operation S103, the controller 220 may calculate a voltage change function with respect to a charging/discharging rate (C-rate) of the battery cells 110, 120, 130, and 140 based on the battery data arranged at specific intervals with respect to the SOC of the plurality of battery cells 110, 120, 130, and 140.

In operation S103, the controller 220 may calculate the voltage change function with respect to the charging/discharging rate of the plurality of battery cells 110, 120, 130, and 140 based on battery data in a specific lifetime state of the plurality of battery cells 110, 120, 130, and 140 among the battery data. Herein, the specific lifetime state may include a BOL, an MOL in operation S103, and an EOL of the battery.

In operation S103, according to an embodiment, the controller 220 may calculate the voltage change function with respect to the charging/discharging rate of the plurality of battery cells 110, 120, 130, and 140 based on battery data in the BOL state of the plurality of battery cells 110, 120, 130, and 140 among the battery data.

In operation S103, the controller 220 may extract predetermined battery data included in the battery data in the BOL state of the plurality of battery cells 110, 120, 130, and 140. In operation S103, the controller 220 may extract first battery data that is charging data (indicating a positive (+) C-rate) of the battery, second battery data that is discharging data (indicating a negative (-) C-rate) of the battery, and third battery data that is OCV data (indicating a C-rate of '0') of the battery, among the battery data in the BOL state of the plurality of battery cells 110, 120, 130, and 140.

In operation S103, the controller 220 may fit the first battery data, the second battery data, and the third battery data. For example, the controller 220 may fit the voltage V data with respect to the C-rate of the battery cell, included in the first battery data, the second battery data, and the third battery data. In operation S103, the controller 220 may calculate the voltage change function with respect to the charging/discharging rate of the plurality of battery cells 110, 120, 130, and 140 by fitting the first battery data, the second battery data, and the third battery data.

In operation S103, the controller 220 may extract a gradient value of a graph formed by fitting the first battery data, the second battery data, and the third battery data. In operation S103, that is, the controller 220 may calculate a quadratic coefficient C of the voltage change function with respect to the charging/discharging rate of the plurality of battery cells 110, 120, 130, and 140, calculated by fitting the first battery data, the second battery data, and the third battery data.

In operation S104, the controller 220 may generate OCV change information with respect to the SOC of the plurality of battery cells 110, 120, 130, and 140 based on the voltage change function with respect to the C-rate in the BOL state of the plurality of battery cells 110, 120, 130, and 140, and the voltage change information with respect to the SOC of the plurality of battery cells 110, 120, 130, and 140.

In operation S104, more specifically, the controller 220 may calculate the OCV for each SOC of the plurality of battery cells 110, 120, 130, and 140 by applying the voltage change information with respect to the SOC of the plurality of battery cells 110, 120, 130, and 140 and the quadratic coefficient C of the voltage change function with respect to the charging/discharging rate in the BOL state of the plurality of battery cells 110, 120, 130, and 140 to interpolation.

In operation S104, the controller 220 may obtain charging data D1 (indicating a positive (+) C-rate) and discharging data D2 (indicating a negative (-) C-rate) for each SOC, generated by dividing the voltage change information with respect to the SOC of the plurality of battery cells 110, 120, 130, and 140 by SOC. In operation S104, that is, the controller 220 may obtain two data points corresponding to the charging data D1 and the discharging data D2 for each SOC of the plurality of battery cells 110, 120, 130, and 140.

In operation S104, the controller 220 may perform quadratic fitting that fits the two data points corresponding to the charging data D1 and the discharging data D2 for each SOC of the plurality of battery cells 110, 120, 130, and 140 and the quadratic coefficient C of the voltage change function with respect to the charging/discharging rate in the BOL state of the plurality of the battery cells 110, 120, 130, and 140. In operation S104, that is, the controller 220 may use '0' C-rate interpolation that connects two points by using the two data points corresponding to the charging data D1 and the discharging data D2 for each SOC and the quadratic coefficient C, and then fins a point at which an x coordinate is '0'.

More specifically, the controller 220 may apply the two data points corresponding to the charging data D1 and the discharging data D2 for each SOC of the plurality of battery cells 110, 120, 130, and 140 and the quadratic coefficient C of the voltage change function with respect to the charging/discharging rate of the plurality of battery cells 110, 120, 130, and 140 to interpolation to extract an OCV that is a voltage value of the battery when a charging/discharging rate of the battery is '0', thereby calculating an OCV for each SOC of the battery.

In operation S104, the controller 220 may calculate an OCV for each SOC of the plurality of battery cells 110, 120, 130, and 140 and then collect the OCV for each SOC of the plurality of battery cells 110, 120, 130, and 140 to generate OCV change information with respect to the SOC of the plurality of battery cells 110, 120, 130, and 140.

In operation S104, the controller 220 may generate OCV change information with respect to an SOC of the plurality of battery cells 110, 120, 130, and 140 by connecting the OCV calculated for each SOC of the plurality of battery cells 110, 120, 130, and 140.

In operation S104, the controller 220 may input the OCV for each SOC of the plurality of battery cells 110, 120, 130, and 140 into a window-based filter for smoothing and generate the OCV change information with respect to the SOC of the plurality of battery cells 110, 120, 130, and 140.

In operation S104, the controller 220 may input the OCV for each SOC of the plurality of battery cells 110, 120, 130, and 140 to the window-based filter for smoothing. The controller 220 may derive a smooth OCV curve by smoothing the OCV for each SOC of the plurality of battery cells 110, 120, 130, and 140.

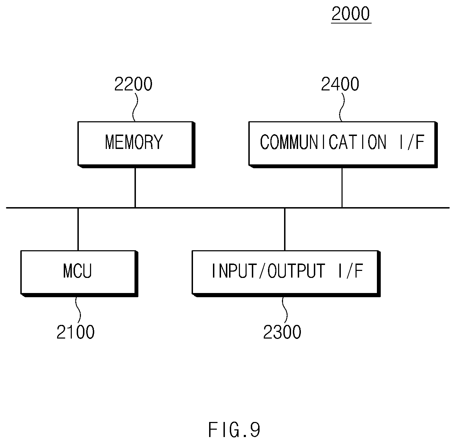

FIG. 9 is a block diagram showing a hardware configuration of a computing system for performing an operating method of a battery data management apparatus, according to an embodiment disclosed herein.

Referring to FIG. 9, a computing system 2000 according to an embodiment disclosed herein may include a microcontroller unit (MCU) 2100, a memory 2200, an input/output interface (I/F) 2300, and a communication I/F 2400.

The MCU 2100 may be a processor that executes various programs (e.g., a battery voltage change function, etc.) stored in the memory 2200, processes various data through these programs, and perform the above-described functions of the battery data management apparatus 200 shown in FIG. 1.

The memory 2200 may store various programs regarding operations of the facility control device 200. Moreover, the memory 2200 may store operation data of the facility control device 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

As such, a computer program according to an embodiment disclosed herein may be recorded in the memory 2200 and processed by the MCU 2100, thus being implemented as a module that performs respective functions of the battery data management apparatus 200 shown in FIGS. 1 and 2.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

### [Description of Symbols]

1000: Battery Pack
100: Battery Module
200: Battery Data Management Apparatus
210: Data Managing Unit
220: Controller
2000: Computing System
2100: MCU
2200: Memory
2300: Input/Output I/F
2400: Communication I/F
300: Relay
D1: Charging Data
D2: Discharging Data
C: Quadratic Coefficient

## Claims

1. A battery data management apparatus comprising:
a data managing unit configured to generate voltage change information with respect to a state of charge (SOC) of a battery, based on battery data; and
a controller configured to calculate a voltage change function with respect to a charging/discharging rate (C-rate) of the battery based on battery data in a specific lifetime state of the battery among the battery data and generate open circuit voltage (OCV) change information with respect to the SOC of the battery based on the voltage change function with respect to the C-rate of the battery and the voltage change information with respect to the SOC of the battery.

2. The battery data management apparatus of claim 1, wherein the data managing unit is further configured to remove noise of the voltage change information with respect to the SOC of the battery by using a Kalman filter.

3. The battery data management apparatus of claim 2, wherein the data managing unit is further configured to divide the voltage change information with respect to the SOC of the battery by the SOC and arrange the voltage change information at specific intervals.

4. The battery data management apparatus of claim 3, wherein the controller is further configured to calculate a quadratic coefficient of the voltage change function with respect to the C-rate of the battery by fitting voltage data with respect to a predetermined C-rate of the battery, included in battery data in a beginning of life (BOL) state of the battery.

5. The battery data management apparatus of claim 4, wherein the controller is further configured to:
divide the voltage change information with respect to the SOC of the battery into charging data and discharging data for each SOC of the battery; and
calculate the voltage change information with respect to the C-rate for each SOC of the battery by applying the charging data and the discharging data for each SOC of the battery and the quadratic coefficient to interpolation.

6. The battery data management apparatus of claim 4, wherein the controller is further configured to calculate the OCV for each SOC of the battery by extracting an OCV that is a voltage value of the battery when the C-rate of the battery is '0' from the voltage change information with respect to the C-rate for each SOC of the battery.

7. The battery data management apparatus of claim 4, wherein the controller is further configured to generate OCV change information with respect to the SOC by inputting the OCV for each SOC of the battery to a window filter to smooth the OCV.

8. An operating method of a battery data management apparatus, the operating method comprising:
generating voltage change information with respect to a state of charge (SOC) of a battery, based on battery data;
removing noise of the voltage change information with respect to the SOC of the battery by using a Kalman filter;
calculating a voltage change function with respect to a charging/discharging rate (C-rate) of the battery based on battery data in a specific lifetime state of the battery among the battery data; and
generating open circuit voltage (OCV) change information with respect to the SOC of the battery based on the voltage change function with respect to the C-rate of the battery and the voltage change information with respect to the SOC of the battery.

9. The operating method of claim 8, wherein the generating of the voltage change information with respect to the SOC of the battery based on the battery data comprises dividing the voltage change information with respect to the SOC of the battery by the SOC and arrange the voltage change information at specific intervals.

10. The operating method of claim 9, wherein the calculating of the voltage change function with respect to the C-rate of the battery based on the battery data in the specific lifetime state of the battery among the battery data comprises calculating a quadratic coefficient of the voltage change function with respect to the C-rate of the battery by fitting voltage data with respect to a predetermined C-rate of the battery, included in battery data in a beginning of life (BOL) state of the battery.

11. The operating method of claim 10, wherein the generating of the OCV change information with respect to the SOC of the battery based on the voltage change function with respect to the C-rate of the battery and the voltage change information with respect to the SOC of the battery comprises dividing the voltage change information with respect to the SOC of the battery into charging data and discharging data for each SOC of the battery and calculating the voltage change information with respect to the C-rate for each SOC of the battery by applying the charging data and the discharging data for each SOC of the battery and the quadratic coefficient to interpolation.

12. The operating method of claim 11, wherein the generating of the OCV change information with respect to the SOC of the battery based on the voltage change function with respect to the C-rate of the battery and the voltage change information with respect to the SOC of the battery comprises calculating the OCV for each SOC of the battery by extracting an OCV that is a voltage value of the battery when the C-rate of the battery is '0' from the voltage change information with respect to the C-rate for each SOC of the battery.

13. The operating method of claim 12, wherein the generating of the OCV change information with respect to the SOC of the battery based on the voltage change function with respect to the C-rate of the battery and the voltage change information with respect to the SOC of the battery comprises generating OCV change information with respect to the SOC by inputting the OCV for each SOC of the battery to a window filter to smooth the OCV.
